Europäisches Patentamt

European Patent Office

Office européen des brevets

(11) Publication number: **0 496 360 A2**

# EUROPEAN PATENT APPLICATION

(21) Application number: **92100944.5**

(22) Date of filing: **21.01.92**

(51) Int. Cl.5: **G11C 11/412**

(30) Priority: **25.01.91 JP 25352/91**

(43) Date of publication of application:
**29.07.92 Bulletin 92/31**

(84) Designated Contracting States:
**DE FR GB**

(71) Applicant: **SONY CORPORATION**
**7-35, Kitashinagawa 6-chome Shinagawa-ku**
**Tokyo(JP)**

(72) Inventor: **Sasaki, Masayoshi**
**c/o Sony Corporation, 7-35 Kitashinagawa**
**6-chome**
**Shinagawa-ku, Tokyo(JP)**

(74) Representative: **TER MEER - MÜLLER -**
**STEINMEISTER & PARTNER**
**Mauerkircherstrasse 45**
**W-8000 München 80(DE)**

(54) **Semiconductor memory cell.**

(57) In a structure of a memory cell including a pair of driver transistors (12, 13) of a first conductivity type and a pair of load transistors (14, 15) of a second conductivity type having active layers (62, 63) formed by semiconductor thin films, a shield electrode (72) is formed through an insulating interlayer on surfaces opposite to surfaces of the load transistors (14, 15) on a side opposite to gate electrodes (14a, 15a), and the potential of the shield electrode (72) is set such that no parasitic channels are formed in the load transistors (14, 15) at least when the memory cell does not read data, or the potential of bit lines (24, 25) formed on the surfaces of the load transistors (14, 15) on the side opposite of the gate electrodes (14a, 15a) are set such that no parasitic channels are formed in the load transistors (14, 15), thereby decreasing current consumption of a semiconductor memory device on a standby state.

*FIG.4*

## BACKGROUND OF THE INVENTION

Field of the Invention

The present invention relates to the structure of a memory cell of a semiconductor memory device which is a so-called SRAM using a TFT load, i.e., a transistor formed on a semiconductor thin film is used as a load.

Description of the Prior Art

In a conventional static memory, high-resistance polysilicon is used as a load of a flip-flop constituting a memory cell, and the high-resistance polysilicon is stacked on a driver transistor for a high integration. In recent years, a memory capacity is increased, and necessity of decreasing current consumption in a data retaining state is increased. For this reason, a memory cell in which a transistor having a channel formed by a semiconductor thin film is stacked on a driver transistor is introduced in Symposium on VLSI Technology Digest of Technical Papers, June 4, 1990, pp. 23 - 24.

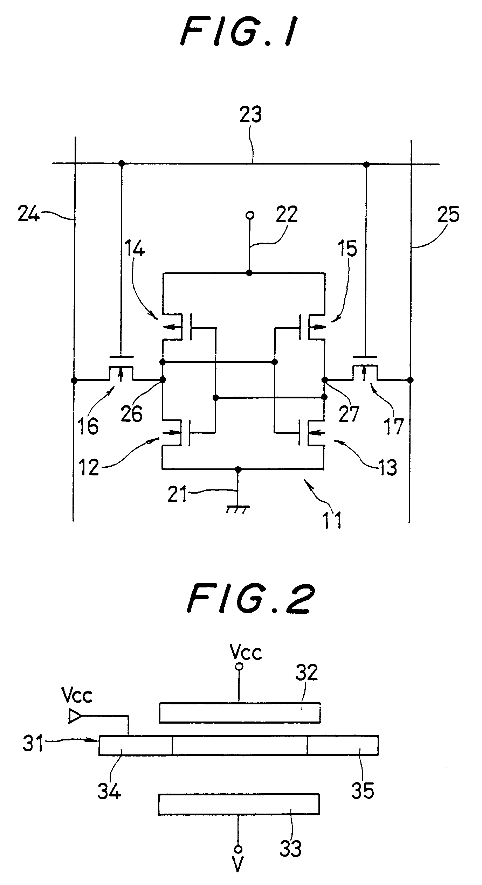

Fig. 1 shows an equivalent circuit of a memory cell of an SRAM using a TFT load. A flip-flop 11 of this memory cell is constituted by a pair of driver NMOS transistors 12 and 13 and a pair of load PMOS transistors 14 and 15 as TFTs (Thin Film Transistors), and the memory cell is constituted by the flip-flop 11 and a pair of transfer NMOS transistors 16 and 17.

The source regions of the pair of NMOS transistors 12 and 13 are connected to a ground line 21, the source regions of the pair of PMOS transistors 14 and 15 are connected to a power supply line 22.

A word line 23 serves as the gate electrodes of the pair of NMOS transistors 16 and 17, and the source/drain region of each of the NMOS transistors 16 and 17 is connected to a corresponding one of a pair of positive and inverse bit lines 24 and 25.

In the SRAM using a TFT load, when one node 26 and the other node 27 of a memory cell are set in high logic level and low logic level, respectively, the PMOS transistor 14 and the NMOS transistor 13 are set in an ON state, and the PMOS transistor 15 and the NMOS transistor 12 are set in an OFF state.

A current flowing in a standby state, which is a problem in the above description, is determined by leak currents of OFF transistors. Therefore, in the above case, a total leak current is obtained by summing up a leak current of the NMOS transistor 12 and a leak current of the PMOS transistor 15. However, since the leak current of the NMOS transistor 12 as a bulk transistor is actually small, the standby current is dominated by the leak current flowing through the PMOS transistor 15.

In addition, the PMOS transistors 14 and 15 are stacked above the NMOS transistors 12 and 13 and the like. For this reason, as shown in Fig. 2, although a gate electrode 32 opposes to an active layer 31 of the PMOS transistors 14 and 15, a conductive layer opposite to the gate electrode 32 can serve as a parasitic gate electrode 33.

When the PMOS transistor 15 is set in an OFF state, the gate electrode 32 is set in a power supply voltage Vcc level. In this state, a leak current flowing between a source region 34 and a drain region 35 is taken into consideration. In addition, if the potential of the parasitic gate electrode 33 is set to be 0 V, a parasitic MOS transistor constituted by the active layer 31 and the parasitic gate electrode 33 are turned on, a current flows between the source region 34 and the drain region 35.

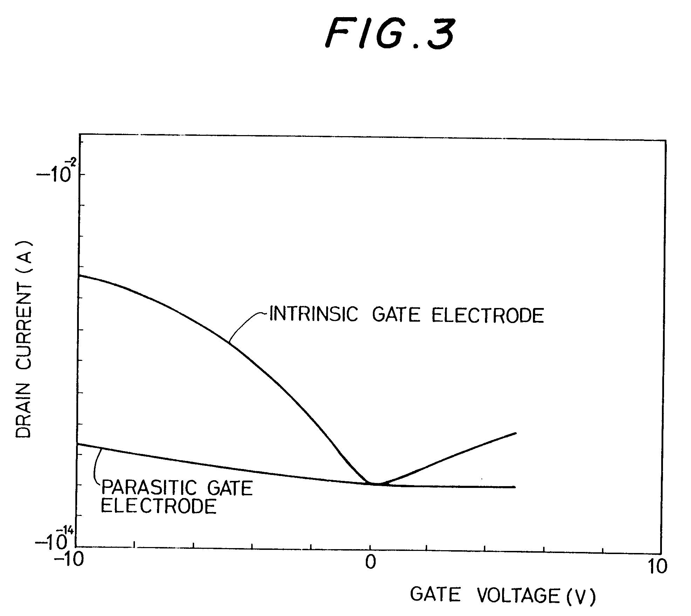

This state is shown in Fig. 3. According to Fig. 3, it is apparent that the leak currents of the PMOS transistors 14 and 15 are increased as the potential of the parasitic gate electrode 33 is negatively increased. Therefore, in a conventional SRAM using a TFT load, the leak currents of the PMOS transistors 14 and 15 are too large. For this reason, a standby current is increased, and power consumption cannot be easily decreased.

## SUMMARY OF THE INVENTION

According to the present invention, there is provided a semiconductor memory cell comprising a pair of driver transistors 12 and 13 of a first conductivity type and a pair of load transistors 14 and 15 of a second conductivity type having active layers formed by semiconductor thin films, wherein a shield electrode 72 or a pair of bit lines 24 and 25 opposite to active layers 62 and 63 are formed on given surfaces of the active layers 62 and 63 of the pair of load transistors 14 and 15, the given surfaces being opposite to surfaces opposite to gate electrodes 14a and 15a of the pair of load transistors 14 and 15, and potentials of the shield electrode 72 or the pair of bit lines 24 and 25 are kept such that no parasitic channels are formed in the load transistors 14 and 15 at least in a standby state.

With the above structure, at least in a standby state, the shield electrode 72 or the pair of bit lines 24 and 25 prevent parasitic channels from being formed in the load transistors 14 and 15. Therefore, a leak current generated due to a parasitic MOS effect of the load transistors 14 and 15 can be suppressed to decrease a standby current.

## BRIEF DESCRIPTION OF THE DRAWINGS

Fig. 1 is an equivalent circuit diagram of a memory cell of an SRAM using a TFT load to which the present invention is applied;

Fig. 2 is a side view showing a TFT for explaining a parasitic MOS effect;

Fig. 3 is a graph showing gate voltage vs. drain current characteristics for explaining the parasitic MOS effect;

Fig. 4 is a sectional view showing a memory cell along a line IV - IV in Fig. 5 according to the first embodiment of the present invention;

Fig. 5 is a plan view showing the memory cell according to the first embodiment of the present invention;

Fig. 6 is a circuit diagram of the memory cell according to the first embodiment of the present invention;

Fig. 7 is a sectional view showing a memory cell along a line VII - VII in Fig. 8 according to the third embodiment of the present invention;

Fig. 8 is a plan view showing the memory cell according to the third embodiment of the present invention; and

Fig. 9 is a circuit diagram showing the memory cell according to the third embodiment of the present invention.

## DETAILED DESCRIPTION OF THE PREFERRED EMBODIMENTS

Embodiments of the present invention will be described below with reference to the accompanying drawings.

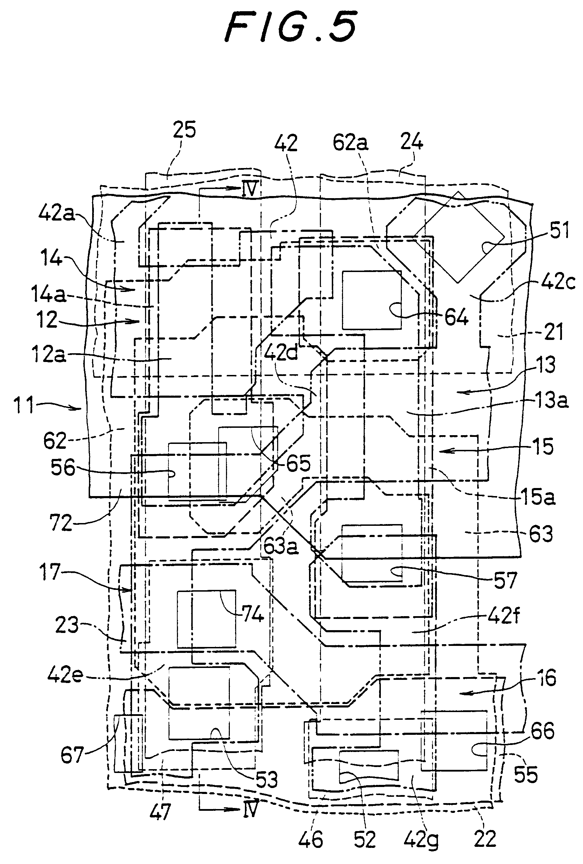

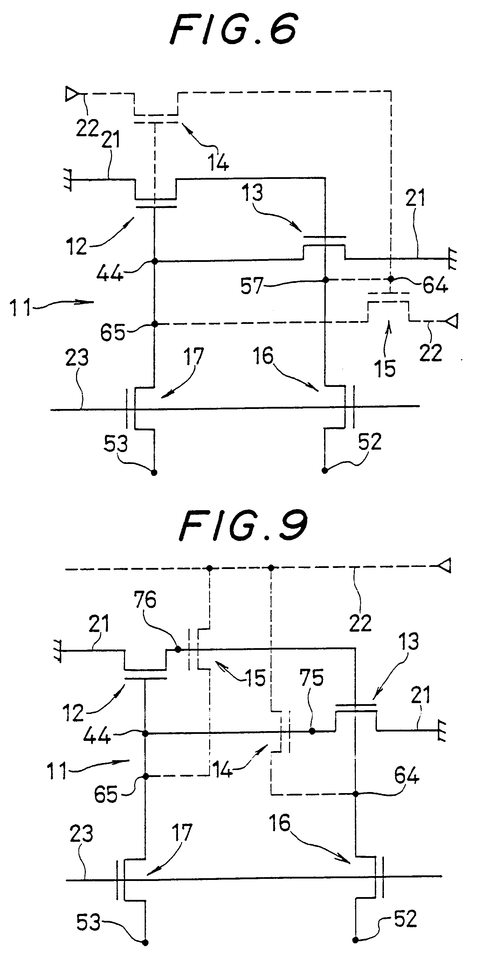

In the first embodiment shown in Figs. 1 to 6, $n^+$-type diffusion layers 42a to 42g serving as source/drain regions of NMOS transistors 12, 13, 16, and 17 are formed in an active region of a silicon substrate 41. Gate electrodes 12a and 13a of the NMOS transistors 12 and 13 and a word line 23 are formed on a field insulating film 43 on the silicon substrate 41 by a first polycide layer. The gate electrode 12a is into contact with the $n^+$-type diffusion layer 42d through a contact hole 44 formed in the field insulating film 43, and the gate electrode 13a is in contact with the $n^+$-type diffusion layers 42b and 42f.

The surfaces of the gate electrodes 12a and 13a, the word line 23, the silicon substrate 41 are covered with a first insulating interlayer 45, and a ground line 21 and wiring layers 46 and 47 are formed on this first insulating interlayer 45 by a second polycide layer.

The ground line 21 is in contact with the $n^+$-type diffusion layers 42a and 42c through a contact hole 51 and the like formed in the first insulating interlayer 45 and the field insulating film 43. The wiring layers 46 and 47 are in contact with the $n^+$-type diffusion layers 42g and 42e through contact holes 52 and 53 formed in the first insulating interlayer 45 and the field insulating layer 43, respectively.

The ground line 21, the wiring layers 46 and 47, and the like are covered with a second insulating interlayer 54, gate electrodes 14a and 15a of PMOS transistors 14 and 15 and a shunt 55 of the power supply line 22 are formed on the insulating interlayer 54 by a third polysilicon layer.

The gate electrodes 14a and 15a are in contact with the gate electrodes 12a and 13a of the NMOS transistors 12 and 13 through contact holes 56 and 57 formed in the first and second insulating interlayers 45 and 54, respectively.

The gate electrodes 14a and 15a, the shunt 55 of the power supply line 22, and the like are covered with a gate insulating film 61, and the power supply line 22 and active layers 62 and 63 of the PMOS transistors 14 and 15 continuing to the power supply line 22 are formed on the gate insulating layer 61 by a fourth polysilicon layer.

Drain regions 62a and 63a in the active layers 62 and 63 are respectively in contact with the gate electrodes 15a and 14a through contact holes 64 and 65 formed in the gate insulating film 61. The power supply line 22 is in contact with the shunt 55 through contact holes 66 and 67 formed in the gate insulating film 61.

The power supply line 22, the active layers 62 and 63, and the like are covered with a third insulating interlayer 71, and a shield electrode 72 is formed on the third insulating interlayer 71 by a fifth polysilicon layer. The potential of the shield electrode 72 is fixed to a power supply voltage Vcc level.

The shield electrode 72 and the like are covered with a fourth insulating interlayer 73, and a contact hole 74 and the like reaching the wiring layers 46 and 47 above the word line 23 are formd to extend through the third and fourth insulating interlayers 71 and 73 and the like. The contact hole 74 and the like are buried with a tungsten layer 75 and the like.

Bit lines 24 and 25 are formed on the fourth insulating interlayer 73 by a metal layer. The bit lines 24 and 25 are in contact with the tungsten layer 75, and the bit lines 24 and 25 are respectively in contact with the $n^+$-type diffusion layers 42g and 42e through the tungsten layer 75 and the wiring layers 46 and 47.

In the first embodiment as described above, since the shield electrode 72 having a potential fixed to a Vcc level is arranged between the active layers 62 and 63 and the bit lines 24 and 25, this shield electrode 72 shields an electric field generated by the bit lines 24 and 25. Therefore, the shield electrode 72 prevents the bit lines 24 and 25 from functioning as the parasitic gate electrodes of the PMOS transistors 14 and 15.

Since the gate electrodes 14a and 15a of the PMOS transistors 14 and 15 themselves are arranged between the active layers 62 and 63 and the ground line 21, the ground line 21 does not function as a parasitic gate electrode. Note that, in the first embodiment, although the potential of the shield electrode 72 is fixed to a Vcc level, the potential of the shield electrode 72 may be biased to the Vcc level in only a standby state.

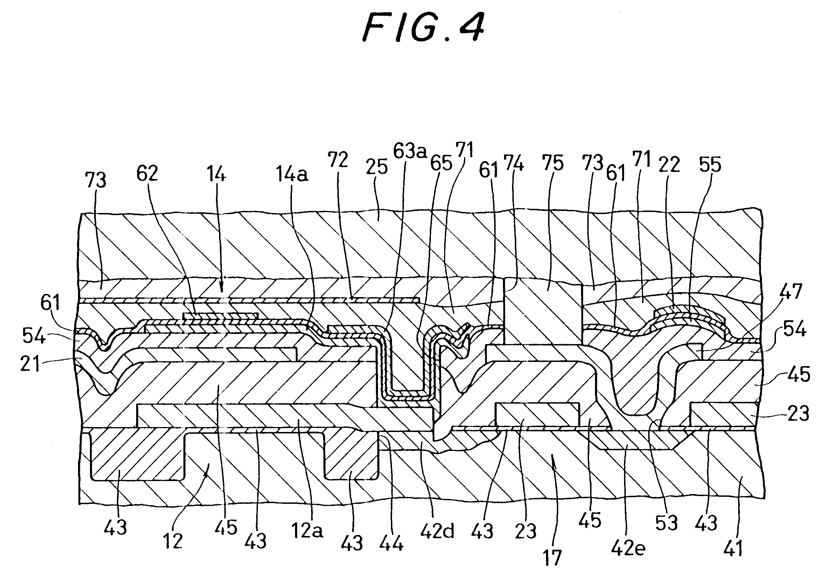

The second embodiment of the present invention will be described below. The second embodiment has the same structure as described in the first embodiment shown in Figs. 4 to 6 except that a shield electrode 72 is not arranged.

According to the second embodiment, in place of structure of a shield electrode fixed to a Vcc level, the potentials of bit lines 24 and 25 are fixed to the Vcc level in a standby state. Therefore, since the bit lines 24 and 25 do not function as parasitic electrodes, current consumption is suppressed in the standby state. The second embodiment has the above structure because the current consumption in the standby state is most important for obtaining low power consumption.

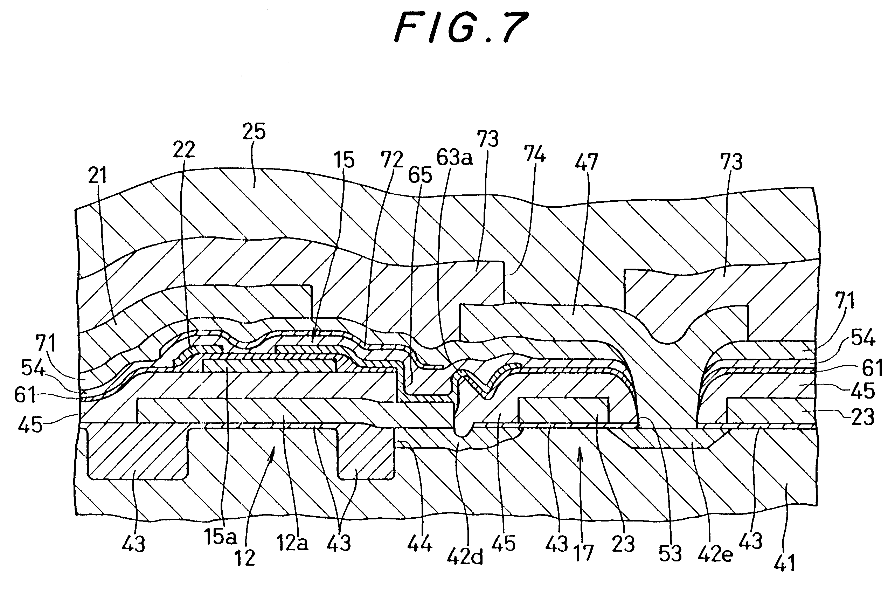

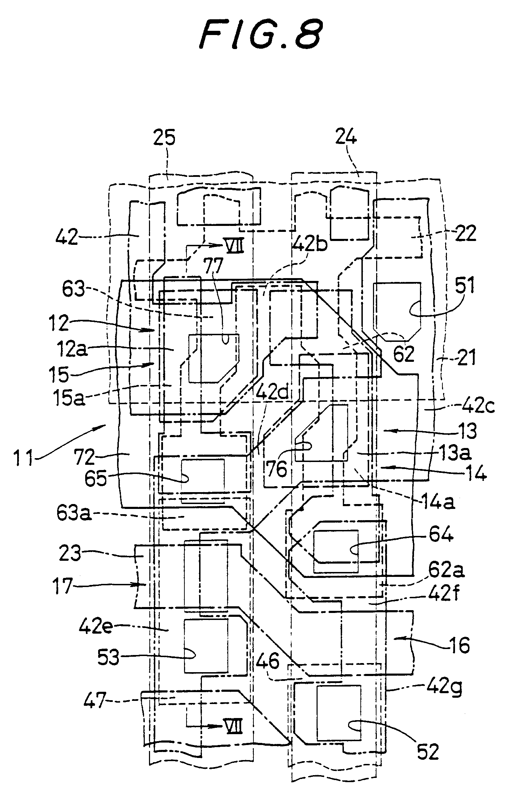

The third embodiment is shown in Figs. 7 to 9. The third embodiment has substantially the same structure as described in the first embodiment shown in Figs. 4 to 6 except for the following structure. Gate electrodes 14a and 15a of PMOS transistors 14 and 15 are formed by a second polysilicon layer, and a power supply line 22 and active layers 62 and 63 of the PMOS transistors 14 and 15 are formed by a third polysilicon layer. In addition, a shield electrode 72 is formed by a fourth polysilicon layer, and a ground line 21 and wiring layers 46 and 47 are formed by tungsten layers.

According to the third embodiment, in contrast to the first embodiment, the PMOS transistor 15 is stacked on an NMOS transistor 12, and the PMOS transistor 14 is stacked on an NMOS transistor 13. For this reason, the gate electrodes 14a and 15a of the PMOS transistors 14 and 15 are in contact with $n^+$-type diffusion layers 42d and 42b through contact holes 76 and 77, respectively.

According to the third embodiment as described above, the ground line 21 is formed above the active layers 62 and 63, and the gate electrodes 14a and 15a are not interposed between the ground line 21 and the active layers 62 and 63. However, since the shield electrode 72 is interposed between the ground line 21 and the active layers 62 and 63, the ground line 21 does not function as parasitic gate electrodes of the PMOS transistors 14 and 15.

Although bit lines 24 and 25 have the ground potential only when data is written in a memory cell, the ground line 21 is always set in the ground potential. Therefore, an effect of the arrangement of the shield electrode 72 is larger in the third embodiment than in the first embodiment.

**Claims**

1. A semiconductor memory cell comprising a flip-flop (11) constituted by a pair of driver transistors (12, 13) of a first conductivity type and a pair of load transistors (14, 15) of a second conductivity type, a pair of transfer transistors of the first conductivity type, a word line (23), a pair of bit lines (24, 25), a power supply line (22), and a ground line (21),
   wherein active layers (62, 63) of said load transistors are formed by semiconductor thin films, a conductive film (72) is formed through an insulating interlayer on surfaces opposite to surfaces of said load transistors on a side opposite to gate electrodes (14a, 15a), and further wherein a potential of said conductive film (72) is set such that no parasitic channels are formed in said load transistors at least when said memory cell does not read data.

2. A semiconductor memory cell comprising a flip-flop (11) constituted by a pair of driver transistors (12, 13) of a first conductivity type and a pair of load transistors (14, 15) of a second conductivity type, a pair of transfer transistors of the first conductivity type, a word line (23), a pair of bit lines (24, 25), a power supply line (22), and a ground line (21),
   wherein active layers (62, 63) of said load transistors are formed by semiconductor thin films, said pair of bit lines are formed through an insulating interlayer on surfaces opposite to surfaces of said load transistors on a side opposite to gate electrodes (14a, 15a), and further wherein potentials of said pair of bit lines are set such that no parasitic channels are formed in said load transistors at least when said memory cell does not read data.

3. A semiconductor memory cell comprising a flip-flop (11) constituted by a pair of driver transistors (12, 13) of a first conductivity type and a pair of load transistors (14, 15) of a second conductivity type, a pair of transfer transistors of the first conductivity type, a word line (23), a pair of bit lines (24, 25), a power supply line (22), and a ground line (21),
   wherein active layers (62, 63) of said load transistors are formed by semiconductor thin films, said ground line is formed on surfaces opposite to surfaces of said load transistors on a side opposite to gate electrodes (14a, 15a), a conductive film (72) is formed between said ground line and said active layers (62, 63) of said load transistors through an insulating interlayer, and further wherein potentials of said conductive layer (72) are set such that no parasitic channels are formed in said load transistors at least when said memory cell does not read data.

# FIG. 1

# FIG. 2

# FIG.3

EP 0 496 360 A2

FIG.4

# FIG.5

## FIG.6

## FIG.9

FIG.7

# FIG.8